# EUROPÄISCHE PATENTSCHRIFT

(11) **EP 2 086 701 B1**
(45) Veröffentlichungstag und Bekanntmachung des Hinweises auf die Patenterteilung: **21.12.2011**
(21) Anmeldenummer: 06828493.4
(22) Anmeldetag: 28.10.2006
(51) Int. Cl.: B21J 5/00, B23P 15/00, C22C 19/00

(54) **VERFAHREN ZUR HERSTELLUNG MIKROSKOPISCH KLEINER BAUELEMENTE**
METHOD FOR PRODUCING MICROSCOPIC COMPONENTS
PROCÉDÉ DE FABRICATION DE COMPOSANTS DE TAILLE MICROSCOPIQUE

(43) Veröffentlichungstag der Anmeldung: 12.08.2009
(73) Patentinhaber: Technische Universität Braunschweig Carolo-Wilhelmina, 38106 Braunschweig (DE)
(72) Erfinder: RÖSLER, Joachim, 38116 Braunschweig (DE); MUKHERJI, Debashis, 38106 Braunschweig (DE)
(74) Vertreter: Rehmann, Thorsten
(86) Internationale Anmeldenummer: PCT/DE2006/001915
(87) Internationale Veröffentlichungsnummer: WO 2008/052494

(56) Entgegenhaltungen:
- EP-A- 1 493 530
- DE-A1- 4 440 758
- D. MUKHERJI, G. PIGOZZI, F. SCHMITZ, O. NÄTH, J. RÖSLER, G. KOSTORZ: "Nano-structured materials produced from simple metallic alloys by phase separation" NANOTECHNOLOGY, Nr. 16, August 2005 (2005-08), Seiten 2176-2187, XP002430487 in der Anmeldung erwähnt
- K.A. LISTER, S. THOMS, D.S. MACINTYRE, C.D.W. WILKINSON, J.M.R. WEAVER: "Direct imprint of sub-10 nm features into metal using diamond and SiC stamps" J. VAC. SCI. TECHNOL., Bd. B22, Nr. 6, Dezember 2004 (2004-12), Seiten 3257-3259, XP002430488
- DATABASE WPI Week 2006 Derwent Publications Ltd., London, GB; AN 2006-674835 XP002432667 & KR 2005 099 422 A (KOREA INST. MACHINERY & MATERIALS) 13. Oktober 2005 (2005-10-13)
- V. KLOCKE, T. GESANG: "Nanorobotics for micro production technology" PROCEEDINGS CONFERENCE PHOTONICS FABRICATION EUROPE, BRUGGE, BELGIUM, 2002, XP002430489 Gefunden im Internet: URL:www.nanomotor.de/pdf/micro_prod_system _e_lo.pdf> [gefunden am 2007-04-13]
- GRAHAM L.W. CROSS: "TOPICAL REVIEW - THE PRODUCTION OF NANOSTRUCTURES BY MECHANICAL FORMING" J. PHYS. D: APPL. PHYS., September 2006 (2006-09), Seiten R363-R386, XP002430490
- E.M. KUSSUL, D.A. RACHKOVSKI, T.N. BAIDYK, S.A. TALAYEV: "Micromechanical engineering: a basis for the low-cost manufacturing of mechanical microdevices using microequipment" J. MICROMECH. MICROENG., 1996, XP002430491
- J. RÖSLER, D. MUKHERJI, K.SCHOCK, S. KLEINDIEK: "Forging of metallic nona-objects for the fabrication of submicron-size components" NANOTECHNOLOGY, 21. Februar 2007 (2007-02-21), Seiten 1-5, XP002430492

## Beschreibung

Die Erfindung betrifft ein Verfahren zur Herstellung mikroskopisch kleiner Bauelemente.

Bekannt ist die Herstellung von Bauelementen mit Abmessungen oberhalb von 50 µm. Zur Herstellung derartiger Bauelemente werden zunächst durch Mikroguss- oder Pulvermetallurgie-Verfahren Vorkörper hergestellt. Diese Vorkörper werden anschließend durch Mikrozerspanung spanend bearbeitet, um ihnen so die gewünschte Endkontur zu geben.

Nachteilig an derartigen Verfahren ist, dass mit Hilfe von so hergestellten. Bauelementen keine komplexen Maschinen konstruiert werden können, deren Abmessungen deutlich unterhalb von 500 µm liegen. Der Grund hierfür ist, dass eine aus mehreren Bauelementen bestehendes, aus einzelnen freien Bauelementen zusammengesetzte, komplexe Maschine stets zehn- bis fünfzigfach größer ist als die einzelnen Bauelemente, aus denen es besteht. Die Herstellung von Bauelementen mit Abmessungen unterhalb von 1 µm ist bislang nur lithographisch möglich. Freie Bauelemente, die nicht an ein Substrat gekoppelt sind, können so nicht mit vertretbarem Aufwand erhalten werden.

In dem veröffentlichten Aufsatz von D. Mukherji, G. Pigozzi, F. Schmitz, O. Näth, J. Rösler, G. Kostorz : "Nano-structured materials produced from simple metallic alloys by phase separation" werden nano-strukturierte Materialien beschrieben, die durch Separation einer Ausscheidungsphase hergestellt werden. Dabei werden in einer Ni-Basislegierung im Zuge einer Wärmebehandlung γ'-Ausscheidungen erzeugt, sodass die Legierung aus einer γ-Matrix und eingelagerter γ'-Phase besteht. Durch selektives elektrochemisches Auflösen der γ-Matrix werden die γ'-Ausscheidungspartikel separiert und auf diese Weise entsprechende nano-Partikel erzeugt.

Aus der Veröffentlichung von K.A. Lister, S. Thoms, D.S. Macintyre, C.D.W. Wilkinson, J.M.R. Weaver : "Direct imprint of sub-10 nm features into metal using diamond and SiC stamps" ist die so genannte "Imprint"- Technik bekannt, mit der Strukturen im Größenbereich von unter 10 nm direkt auf Ni-Substrate gedruckt werden.

Die DE 44 40 758 A1 offenbart eine elektromagnetische Positioniereinheit, die zum Positionieren und als Werkzeug zur Bearbeitung von mikroskopisch kleinen Partikeln in Raster-Elektronen-Mikroskopen dient. Als Werkzeug ist die Einheit zum Kratzen, Schweißen oder Bonden verwendbar.

Insbesondere für Anwendungen in der Medizin, beispielsweise zur Medikamentenabgabe oder zur Diagnostik mittels implantierter Mikrosysteme, ist es jedoch wünschenswert, komplexe Maschinen zur Verfügung zu haben, deren Abmessungen deutlich unterhalb von 500 µm liegen.

Der Erfindung liegt daher die Aufgabe zu Grunde, ein Verfahren anzugeben, mit dem freie, nicht an ein Substrat gebundene Bauelemente mit einer Größe unterhalb von 10 µm hergestellt werden können.

Die Erfindung löst das Problem durch ein Verfahren mit den Schritten (a) Herstellung einer ausscheidungshärtbaren, mindestens aus zwei Phasen bestehenden Legierung, bei der eine erste Phase eine Matrixstruktur ausbildet, in die eine zweite Phase in Form diskreter Teilchen eingebettet ist, die eine Größe von weniger als 10 µm, vorzugsweise weniger als 1 µm aufweisen (b) Auflösen der Matrix und Separieren von diskreten Teilchen aus der Legierung und (c) mechanische Umformung durch Schmieden jeweils eines separierten Teilchens mit mindestens einem Schlagwerkzeug zu dem gewünschten Bauelement.

Vorteilhaft an dem erfindungsgemäßen Verfahren, das auch als Nanoschmieden bezeichnet werden kann, ist, dass Bauelemente mit einer Größe von weniger als 50 µm herstellbar sind. Vorteilhaft ist zudem, dass Bauelemente mit reproduzierbaren Abmessungen herstellbar sind, da die als Ausgangsblöcke verwendeten Teilchen ebenfalls eine hochgradig reproduzierbare Größe haben.

Vorteilhaft ist außerdem, dass durch das Verfahren schnell große Stückzahlen an Bauelementen hergestellt werden können, da durch die Verwendung der ausscheidungshärtbaren Legierung sehr schnell eine große Anzahl an Teilchen erhalten werden kann.

Vorteilhaft ist zudem, dass das Verfahren ohne lithographische oder pulvermetallurgische Prozesse auskommt, was den apparativen Aufwand reduziert. Das Verfahren ermöglicht es zudem, Bauelemente aus einer Vielzahl von hochfesten Legierungen herzustellen, bei denen lithographische oder pulvermetallurgische Verfahren keine zufrieden stellenden Ergebnisse liefern.

Im Rahmen der vorliegenden Beschreibung bezieht sich die Bezeichnung γ, γ' ganz allgemein auf zwei unterschiedliche Phasen. In einer bevorzugten Ausführungsform ist die erste Phase eine γ-Phase und die zweite Phase eine γ-Phase im metallkundlichen Sinn. Die diskreten Teilchen sind dann beispielsweise γ'-Teilchen.

Unter einer Matrixstruktur wird verstanden, dass diese so in sich zusammenhängt, dass sie sich auflösen lässt und die darin enthaltenen Teilchen, insbesondere die darin enthaltenen γ'-Teilchen, dadurch von der γ-Matrix separiert werden können. Insbesondere sind die γ'-Teilchen durch zeilen- und spaltenartige Bereiche getrennt, in denen die γ-Phase vorliegt. Bevorzugt weist die Legierung mehr als 10, insbesondere mehr als 100 γ'-Teilchen auf, die durch Bereiche voneinander getrennt sind, in denen die γ-Phase vorliegt.

Unter der Größe der γ'-Teilchen ist insbesondere die maximale Seitenlänge eines minimalen Hüllquaders zu verstehen. Zur Ermittlung der Größe eines γ'-Teilchens wird daher der Quader um das betreffende γ'-Teilchen ermittelt, der das γ'-Teilchen vollständig umgibt und unter allen solchen Hüllquadem das kleinste Volumen hat, und dessen maximale Seitenlänge festgestellt. Diese Seitenlänge stellt die Größe des γ'-Teilchens dar.

Unter einem Separieren der γ'-Teilchen aus der Superlegierung ist insbesondere zu verstehen, dass die γ'-Teilchen von dem Rest der Matrixstruktur, insbesondere also von der γ-Phase, getrennt werden. Das Schmieden umfasst insbesondere ein Freiformschmieden, bei dem das separierte γ'-Teilchen mit einem Hammer auf einer ebenen Unterlage geschmiedet wird, und ein Gesenkschmieden, bei dem das γ'-Teilchen von einem Hammer in ein Gesenk geschlagen oder zwischen zwei Gesenken verformt bzw. umgeformt wird.

In einer bevorzugten Ausführungsform sind die γ'-Teilchen im Wesentlichen quaderförmig ausgebildet. Unter einer im Wesentlichen quaderförmigen Gestalt ist zu verstehen, dass eine strenge mathematische Quaderform nicht notwendig ist. Es ist vielmehr ausreichend, wenn beispielsweise die längste Seite eines Hüllquaders minimalen Volumens um das betreffende γ' Teilchen nicht mehr als 15 % länger ist als die kürzeste Seite des entsprechenden Hüllquaders.

Die maximale Kantenlänge des Quaders bzw. des Würfels ist vorzugsweise kleiner als 10 µm, vorzugsweise kleiner als 1 µm. Vorteilhaft hieran ist, dass besonders kleine Bauelemente herstellbar sind.

Bevorzugt erfolgt das Auflösen der Matrix chemisch und/oder elektrochemisch. Hierdurch wird die Matrix besonders schnell und effektiv aufgelöst, ohne dass die γ'-Teilchen übermäßig beeinflusst werden.

In einem bevorzugten Verfahren werden auf der Metalloberfläche gebundene γ'-Teilchen zur Separation mittels Ultraschall abgeschüttelt. Die Metalloberfläche ist dabei insbesondere diejenige Oberfläche der Legierung, mit der die γ'-Teilchen vor dem chemischen und/oder elektrochemischen Auflösen verbunden waren.

Besonders bevorzugt wird das Abschütteln in einer wässrigen Lösung durchgeführt, die anschließend zur Gewinnung der γ'-Teilchen zentrifugiert wird. Hierdurch wird sichergestellt, dass die γ'-Teilchen mit einer hohen Ausbeute gewonnen werden können. Gleichzeitig wird verhindert, dass γ'-Teilchen in die Luft gelangen, wo sie möglicherweise eingeatmet werden könnten.

Bevorzugt ist die Legierung, insbesondere in einzelnen oder allen γ'-Teilchen, einkristallin. Hieraus ergeben sich besonders vorteilhafte Festigkeitseigenschaften der hergestellten Bauelemente.

Besonders vorteilhaft ist das Verfahren, wenn die Legierung eine Nickel-Basis-Superlegierung ist, da in diesem Fall besonders gleichmäßig geformte und im Wesentlichen quaderförmige γ'-Teilchen erzeugt werden können und Bauelemente mit einer besonders hohen mechanischen Festigkeit erhalten werden. Besonders günstig sind Nickel-Basis-Superlegierungen mit 1 bis 9 Gew.% Aluminium, 0-8 Gew.% Titan und 0-15 Gew.% Tantal, insbesondere 0-12 Gew.-% Tantal, beispielsweise Udimet 710 mit 2,3 Gew.-% Aluminium und 3 % Titan oder Waspaloy mit 1,3 Gew.-% Aluminium und 3 % Titan. Derartige Legierungen haben sich zudem für die Herstellung von γ'-Teilchen als besonders vorteilhaft herausgestellt.

Allgemein werden Legierungen bevorzugt, bei denen die γ'-Teilchen eine L1₂-Kristallstruktur aufweisen. Beispielsweise ist die Legierung alternativ eine Nickel-Eisen-Legierung und die γ'-Teilchen umfassen Ni₃Fe. Auf diese Weise werden Bauelemente mit einer besonders hohen Duktilität erhalten, die sich zudem leicht schmieden lassen.

Es ist bevorzugt, dass die Bearbeitungsfläche des Schlagwerkzeugs kleiner ist als 50 µm, insbesondere kleiner als 5 µm. Die Größe der Bearbeitungsfläche wird angegeben als die Seitenlänge eines Quadrats gleicher Fläche.

Bevorzugt werden als Schlagwerkzeug ein Manipulator mit Wolframspitze und als Amboss ein Silizium-Cantilever-Arm eingesetzt. Vorzugsweise weist der Silizium-Cantilever-Arm eine flache Oberfläche auf. Alternativ ist im Silizium-Cantilever-Arm zumindest eine als Gesenk fungierende Ausnehmung vorgesehen. Diese Ausnehmung weist bevorzugt eine Grundfläche auf, deren maximale Abmessung kleiner ist als 5 µm. Auf diese Weise lassen sich besonders kleine Bauelemente herstellen.

Es hat sich herausgestellt, dass die Ausnehmung mit einer besonders hohen Genauigkeit und besonders reproduzierbar durch Nano- oder Mikrolithographie hergestellt werden kann. Zum Schmieden wird in einer bevorzugten Ausführungsform eine Wolframspitze mit einem Plateau eingesetzt, dessen maximale Abmessung kleiner ist als 5 µm. Eine Wolframspitze hat den Vorteil, hinreichend hart zu sein, um sich beim Schmieden nicht selbst zu verformen. Die maximalen Abmessungen von unter 5 µm erlauben es zudem, den Schmiedevorgang beispielsweise durch ein Rasterelektronenmikroskop zu beobachten.

Im Folgenden wird ein Ausführungsbeispiel der Erfindung anhand der beigefügten Zeichnungen näher erläutert. Dabei zeigt
- Figur 1a: eine rasterelektronenmikroskopische Aufnahme einer ausscheidungshärtbaren, aus zwei Phasen bestehenden Nickel-Basis Superlegierung, bei der eine erste Phase (y-Phase) eine Matrixstruktur ausbildet, in die eine zweite Phase in Form diskreter Teilchen (γ'-Phase) eingebettet ist, die eine Größe von weniger als 10 µm aufweisen,
- Figur 1b: eine rasterelektronenmikroskopische Aufnahme der Legierung nach Figur 1a, bei der die γ-Phase entfernt worden ist,
- Figur 2: eine schematische Ansicht eines Manipulators zum Schmieden im Rahmen eines erfindungsgemäßen Verfahrens. Die
- Figuren 3a, 3b, 3c, 3d und 3e: zeigen den Fortschritt eines erfindungsgemäßen Herstellungsverfahrens in Form von rasterelektronenmikroskopischen Aufnahmen.

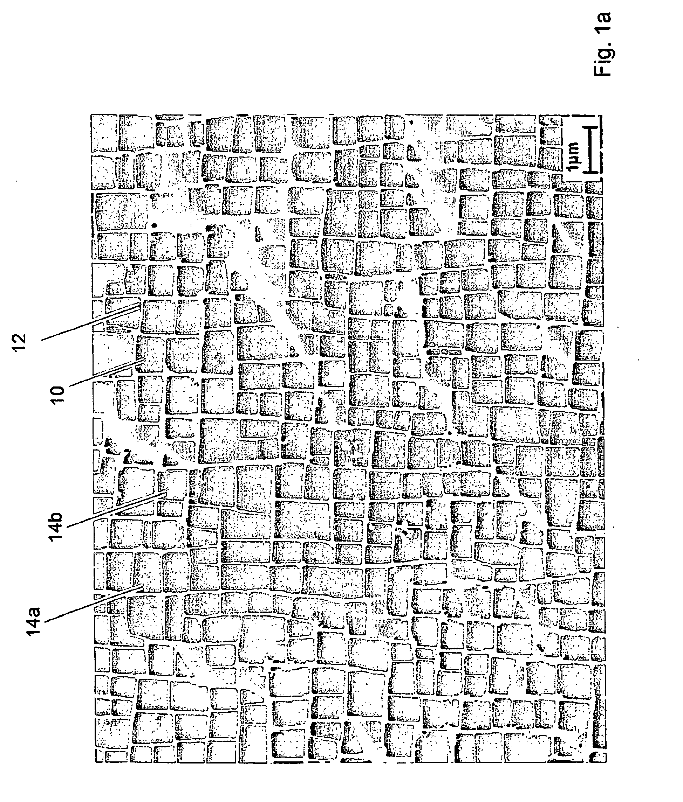

Figur 1a zeigt eine rasterelektronenmikroskopische Aufnahme einer ausscheidungshärtbaren Legierung, die zwei Phasen aufweist, nämlich eine γ'-Phase 10 und eine γ-Phase 12. Die γ-Phase 12 stellt eine erste Phase dar und die γ'-Phase 10 stellt eine zweite Phase dar. Die erste Phase 12 bildet eine Matrixstruktur aus, in die die zweite Phase 10 in Form einer Vielzahl diskreter γ'-Teilchen 14a, 14b,... eingebettet ist, die eine Größe von weniger als 10 µm aufweisen. Die γ'-Teilchen 14 sind zeilen- und spaltenartig angeordnet und durch die γ-Phase 12 voneinander getrennt.

Die in Figur 1a gezeigte Struktur wird durch eine Wärmebehandlung einer Nickel-Basis-Superlegierung SX-1 hergestellt, nämlich durch Lösungsglühen und Ausscheidungshärtung. Diese Nickel-Basis-Superlegierung setzt sich zusammen aus 11,6 At.% Aluminium, 2,4 At.% Tantal, 6 At.-% Chrom, 3,5 At.-% Wolfram, 1,3 At.-% Molybdän und einem Rest aus Nickel und unvermeidbaren Verunreinigungen.

Diese Wärmebehandlung wird so durchgeführt, dass im Wesentlichen würfelförmige Ausscheidungen in Form der γ'-Teilchen 14 vom Ni₃Al-Typ mit einer im Wesentlichen gleichen Größe von 300 nm bis 500 nm erhalten werden. Insbesondere wird die Legierung so wärmebehandelt, dass die auf den Mittelwert bezogene Varianz der Größenverteilung unterhalb von 25% liegt. Details zu der Herstellung finden sich in dem Artikel "Nano-structured materials produced from simple metallic alloys by phase separation" in Nanotechnology 16 (2005) 2176-2187.

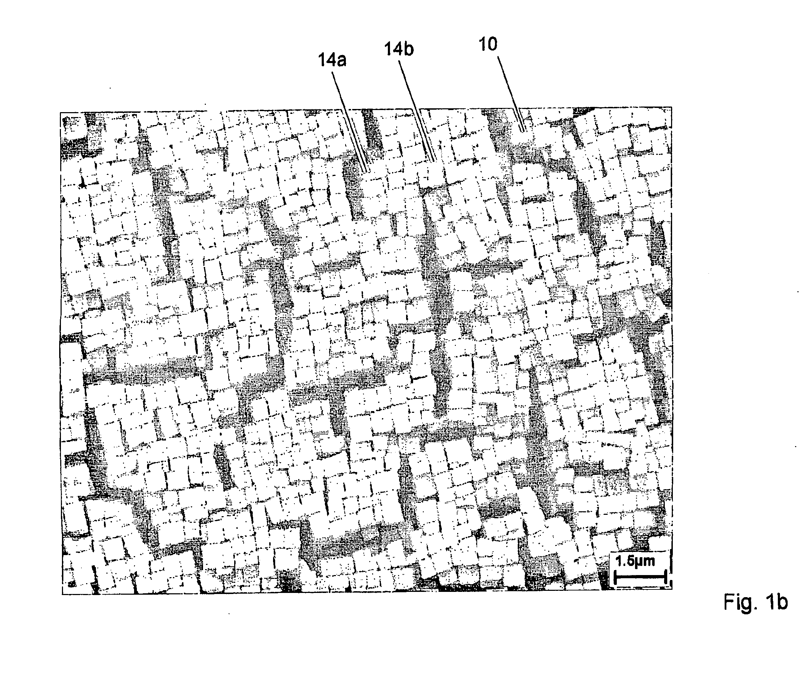

Im Anschluss daran wird das Material, nämlich die γ'-Phase 10 und die γ-Phase 12, in einem wässrigen Elektrolyten elektrochemisch geätzt, wobei die Legierung als Anode geschaltet ist. Dabei werden die Ätzparameter so gewählt, dass die Matrix, nämlich die γ-Phase 12, aufgelöst wird. Nähere Einzelheiten zu den Ätzparametern finden sich in dem oben genannten Artikel. Der Vorgang des Ätzens wird in Intervallen von einer halben Stunde bis zwei Stunden unterbrochen. Es ergibt sich so die in Figur 1 b gezeigte Situation, in der die Matrix in Form der γ-Phase 12 aufgelöst ist und die γ'-Teilchen 14a, 14b, ... verblieben sind.

Anschließend wird die Superlegierung in einer wässrigen Lösung in ein Ultraschallbad überführt. Auf der Metalloberfläche gebundene γ'-Teilchen 14 werden dadurch in die wässrige Lösung abgeschüttelt. Diese mit γ'-Teilchen 14 angereicherte Lösung wird anschließend zentrifugiert und die γ'-Teilchen 14 abgetrennt.

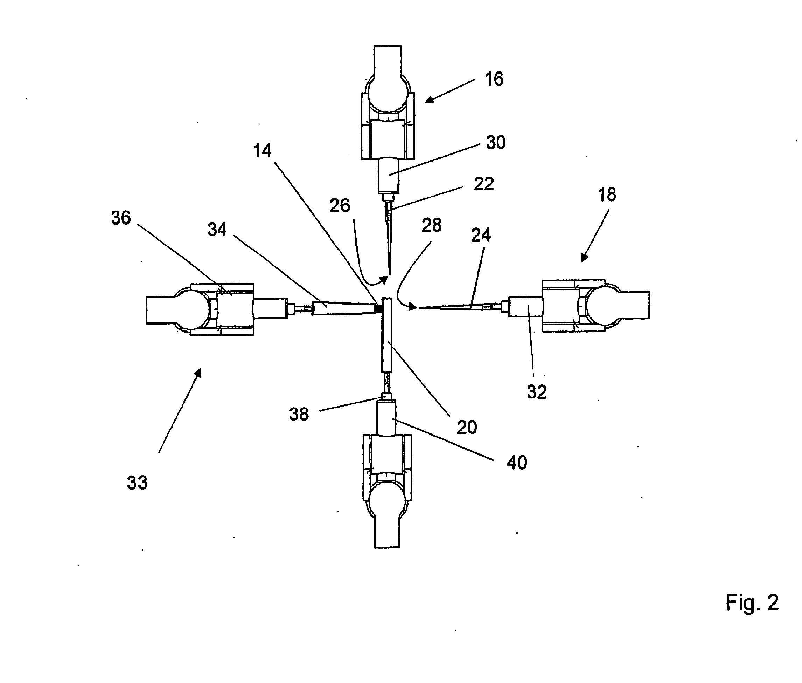

In einem nachfolgenden Verfahrensschritt wird in einer nicht eingezeichneten Vakuumkammer eines Rasterelektronenmikroskops unter Hochvakuum ein einzelnes γ'-Teilchen 14 mit Hilfe eines oder mehrerer, im vorliegenden Fall von zwei Manipulatoren 16, 18 (vgl. Figur 2) aufgenommen und von dem Manipulator bzw. den Manipulatoren 16, 18 auf einem Silizium-Cantilever-Arm 20 abgelegt. Die beiden Manipulatoren 16, 18 weisen jeweils eine Wolframnadel 22 bzw. 24 auf, die jeweils in eine Spitze 26 bzw. 28 mit einem Spitzenradius von 20 nm auslaufen. Die Manipulatoren 16, 18 und die weiteren Komponenten sind von der Fa. Kleindiek Nanotechnik GmbH, Reutlingen, Deutschland zu beziehen.

Die Manipulatoren 16, 18 werden mittels eines Joysticks gesteuert und besitzen Antriebe 30 bzw. 32, mittels deren die Wolframnadeln 22, 24 mit einer Positioniergenauigkeit von 0,5 nm positioniert werden können.

Nach dem Ablegen eines γ'-Teilchens 14 auf dem Silizium-Cantilever-Arm 20 wird das γ'-Teilchen 14 mittels eines Schlagwerkzeugs 33 bearbeitet. Das Schlagwerkzeug 33 umfasst einen Hammer in Form einer Wolframspitze 34. Die Wolframspitze 34 ist an einem piezoelektrischen Hammerantrieb 36 befestigt und hat eine Positioniergenauigkeit in Richtung auf den Silizium-Cantilever-Arm 20 von 1 nm.

Der Hammerantrieb 36, der Silizium-Cantilever-Arm 20 und die beiden Manipulatoren 16, 18 sind so einander paarweise gegenüber angeordnet, dass die Verbindungslinie zwischen Manipulator 16 und Silizium-Cantilever-Arm 20 einerseits und Manipulator 18 und Wolframspitze 34 andererseits senkrecht zueinander verlaufen.

Mit Hilfe des Hammerantriebs 36 können Kräfte bis zu 2 mN aufgebracht werden. Die Stärke der aufgebrachten Kraft wird durch einen Kraftsensor 38 aufgenommen, der in einem Antrieb 40 für den Silizium-Cantilever-Arm 20 angeordnet ist.

Der Schmiedevorgang findet bei Raumtemperatur (23 °C) statt. In einer alternativen Ausführungsform umfasst der Silizium-Cantilever-Arm 20 eine nicht eingezeichnete elektrische Heizvorrichtung. Sofern gewünscht wird so das γ'-Teilchen 14 auf eine erhöhte Temperatur gebracht und anschließend bearbeitet. Es ist zudem möglich, nach einem Schmieden bei Raumtemperatur das γ'-Teilchen 14 mittels der elektrischen Heizvorrichtung zu erhitzen, um Rekristallisationsvorgänge auszulösen und/oder Versetzungen auszuheilen.

Sämtliche in Figur 2 gezeigten Komponenten sind in einer Vakuumkammer eines nicht eingezeichneten Rasterelektronenmikroskops angeordnet. Mit Hilfe des Rasterelektronenmikroskops wird das Freiformschmieden des γ'-Teilchens 14 ständig überwacht.

In einer alternativen Ausführungsform weist der Silizium-Cantilever-Arm 20 eine durch Nano- oder Mikrolithographie erzeugte Ausnehmung auf. Diese Ausnehmung hat eine Grundfläche, deren maximale Abmessung beispielsweise unter 1 µm mal 1 µm liegt. Zum mechanischen Umformen durch Schmieden wird ein einzelnes γ'-Teilchen 14 mit Hilfe der Manipulatoren 16, 18 vereinzelt und auf eine Position oberhalb der Ausnehmung platziert. Anschließend wird mit der Wolframspitze 34 als Hammer das γ'-Teilchen 14 in das Gesenk geschlagen oder gedrückt. Auf diese Weise wird ein umgeformtes Bauelement mit einer genau konturierten Oberfläche und mit einer Größe von weniger als 1 µm erhalten. Ein solches Verfahren ist beispielsweise zur Fertigung von Zahnrädern mit einer Größe von unter 10 µm einsetzbar.

Es ist möglich, nicht aber notwendig, dass das γ'-Teilchen 14 vollständig in das Gesenk geschlagen wird. Alternativ wird das γ'-Teilchen 14 oberhalb des Gesenks platziert und teilweise in das Gesenk geschlagen. Ein außerhalb des Gesenks verbleibender Rest des γ'-Teilchens 14 wird anschließend entfernt.

In einem alternativen Verfahren wird anstelle von Hochvakuum ein schwächeres Vakuum verwendet, beispielsweise ein Feinvakuum. Vorteilhaft ist dann, eine möglichst geringe Luftfeuchtigkeit einzustellen, beispielsweise von unter 10%.

Ein erfindungsgemäßes Verfahren kann die Schritte eines Benetzens des Silizium-Cantilever-Arms 20 und/oder der Wolframspitze 34 mit einer Schmiermittelschicht umfassen. Dieser Verfahrensschritt ist vorteilhaft, wenn zu befürchten ist, dass das aus dem γ'-Teilchen 14 entstandene Bauteil nach dem Schmieden an dem Silizium-Cantilever-Arm 20 bzw. an der Wolframspitze 34 festklebt. Das Benetzen mit einer Schmiermittelschicht wird beispielsweise dadurch erreicht, dass ein Diffusionspumpenöf wie das Diffusionspumpenöl 705 der Fa. Dow . Corning verdampft wird, so dass es sich auf dem Silizium-Cantilever-Arm 20 bzw. der Wolframspitze 34 niederschlägt.

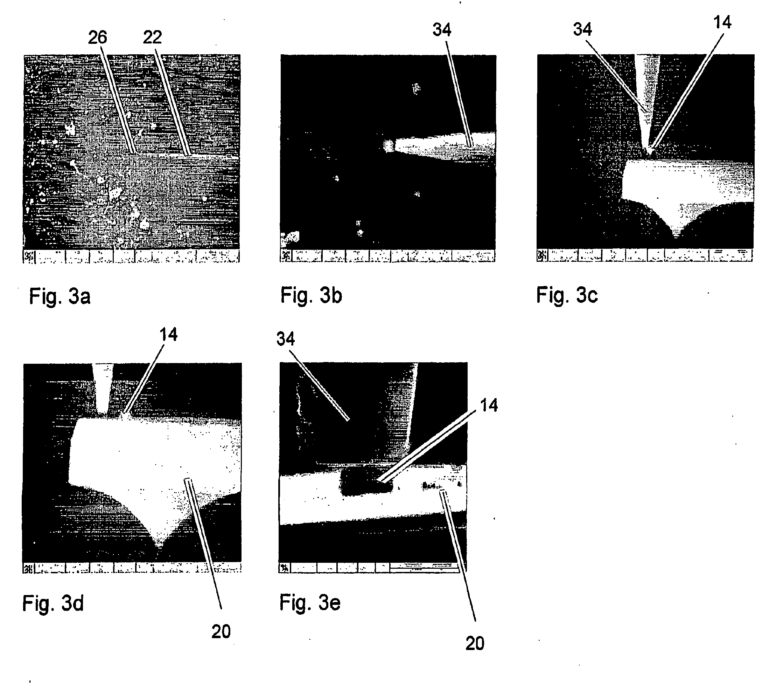

Figur 3a zeigt die Spitze 26 der Wolframnadel 22 des Manipulators 16 (vgl. Figur 2) in einer rasterelektronenmikroskopischen Aufnahme, mittels derer das γ'-Teilchen 14 vereinzelt wird.

Figur 3b zeigt die Wolframspitze 34, an dessen Spitze sich das γ'-Teilchen 14 befindet. Das γ'-Teilchen 14 wird auf dem Silizium-Cantilever-Arm 20 abgelegt (Figuren 3c und 3d) und anschließend mit der Wolframspitze 34 auf dem Silizium-Cantilever-Arm 20 umgeformt (Figur 3e), so dass ein Bauelement erhalten wird.

### Bezugszeichenliste

- 10: zweite Phase (γ'-Phase)
- 12: erste Phase (γ-Phase)
- 14: γ'-Teilchen
- 16: Manipulator
- 18: Manipulator
- 20: Silizium-Cantilever-Arm
- 22: Wolframnadel
- 24: Wolframnadel
- 26: Spitze
- 28: Spitze
- 30: Antrieb
- 32: Antrieb
- 33: Schlagwerkzeug
- 34: Wolframspitze
- 36: Hammerantrieb
- 38: Kraftsensor
- 40: Antrieb

## Patentansprüche

1. Verfahren zur Herstellung mikroskopisch kleiner Bauelemente, **gekennzeichnet durch** folgende Schritte:
a) Herstellung einer ausscheidungshärtbaren, mindestens aus zwei Phasen (γ, γ') bestehenden Legierung, bei der eine erste Phase (γ) eine Matrixstruktur ausbildet, in die eine zweite Phase (γ') in Form diskreter Teilchen (14) eingebettet ist, die eine Größe von weniger als 10 µm aufweisen;
b) Auflösen der Matrix und Separieren von Teilchen (14) aus der Legierung;
c) mechanische Umformung **durch** Schmieden jeweils eines separierten Teilchens (14) mit mindestens einem Schlagwerkzeug (33) zu dem gewünschten Bauelement.

2. Verfahren nach Anspruch 1, **dadurch gekennzeichnet, dass** die Teilchen (14) im Wesentlichen quaderförmig ausgebildet sind.

3. Verfahren nach Anspruch 2, **dadurch gekennzeichnet, dass** die Teilchen (14) im Wesentlichen kubisch ausgebildet sind,

4. Verfahren nach Anspruch 2 oder 3, **dadurch gekennzeichnet, dass** die maximale Kantenlänge kleiner als 10 µm, vorzugsweise kleiner als 1 µm ist.

5. Verfahren nach einem der vorstehenden Ansprüche, **dadurch gekennzeichnet, dass** das Auflösen der Matrix chemisch und/oder elektrochemisch erfolgt.

6. Verfahren nach Anspruch 1 oder 5, **dadurch gekennzeichnet, dass** auf der Metalloberfläche gebundene Teilchen (14) zur Separation mittels Ultraschall abgeschüttelt werden.

7. Verfahren nach Anspruch 6, **dadurch gekennzeichnet, dass** das Abschütteln in einer wässrigen Lösung erfolgt, die zur Gewinnung der Teilchen anschließend zentrifugiert wird.

8. Verfahren nach einem oder mehreren der vorstehenden Ansprüche, **dadurch gekennzeichnet, dass** die Legierung in den Teilchen (14) einkristallin ist.

9. Verfahren nach einem der vorstehenden Ansprüche, **dadurch gekennzeichnet, dass** die Legierung eine Nickel-Basis Superlegierung ist.

10. Verfahren nach einem der vorstehenden Ansprüche, **dadurch gekennzeichnet, dass** die Nickel-Basis Superlegierung 1-9 Gew.-% Aluminium, 0-8 Gew.-% Titan und 0-15 Gew.-% Tantal umfasst.

11. Verfahren nach Anspruch 10, **dadurch gekennzeichnet, dass** sich die Legierung zusammensetzt aus Nickel, Aluminium, Tantal, Chrom, Wolfram und Molybdän, und zwar zu:
11,6 At.% Al, 2,4 At.% Ta, 6 At.% Cr, 3,5 At.% W, 1,3 At.% Mo; der Rest ist Ni und unvermeidbare Verunreinigungen.

12. Verfahren nach einem der Ansprüche 1 bis 8, **dadurch gekennzeichnet, dass** die Legierung eine Nickel-Eisen-Legierung ist und die Teilchen (14) Ni₃Fe umfassen.

13. Verfahren nach Anspruch 1, **dadurch gekennzeichnet, dass** die Bearbeitungsfläche des Schlagwerkzeuges (33) kleiner ist als 50 µm, insbesondere kleiner als 5 µm.

14. Verfahren nach Anspruch 1, **dadurch gekennzeichnet, dass** als Schlagwerkzeug (33) ein Manipulator mit Wolframspitze (34) und als ein Amboss ein Silizium-Cantilever-Arm (20) eingesetzt werden.

15. Verfahren nach Anspruch 14, **dadurch gekennzeichnet, dass** der Silizium-Cantilever-Arm (20) eine flache Oberfläche aufweist.

16. Verfahren nach Anspruch 14, **dadurch gekennzeichnet, dass** der Silizium-Cantilever-Arm (20) zumindest eine als Gesenk fungierende Ausnehmung aufweist.

17. Verfahren nach Anspruch 16, **dadurch gekennzeichnet, dass** die mindestens eine Ausnehmung eine Grundfläche hat, deren maximale Abmessung kleiner ist als 5 µm.

18. Verfahren nach Anspruch 17, **dadurch gekennzeichnet, dass** die Ausnehmung durch Nano- oder Mikrolithographie erzeugt wird.

19. Verfahren nach einem der Ansprüche 14 bis 18, **dadurch gekennzeichnet, dass** die Wolframspitze (34) ein Plateau mit einem Durchmesser von unter 50 µm, insbesondere unter 5 µm aufweist.

20. Verfahren nach einem der Ansprüche 14 bis 19, **dadurch gekennzeichnet, dass** es vollständig in einem Rasterelektronenmikroskop durchgeführt wird.

21. Verfahren nach einem der Ansprüche 14 bis 20, **dadurch gekennzeichnet, dass** es vollständig in Hochvakuum durchgeführt wird.

## Claims

1. Method for producing microscopic components, **characterized by** the following steps:
a) a precipitatiori-hardenable alloy consisting at least of two phases (γ, γ') is produced, in which a first phase (γ) forms a matrix structure in which a second phase (γ') is embedded in the form of discrete particles (14) having a size of less than 10 µm;
b) the matrix is dissolved and particles (14) are separated from the alloy;
c) a respective separated particle (14) is mechanically formed by forging using at least one striking tool (33) to form the desired component.

2. Method according to Claim 1, **characterized in that** the particles (14) have a substantially cuboidal form.

3. Method according to Claim 2, **characterized in that** the particles (14) have a substantially cubic form.

4. Method according to Claim 2 or 3, **characterized in that** the maximum edge length is less than 10 µm, preferably less than 1 µm.

5. Method according to one of the preceding claims, **characterized in that** the matrix is dissolved chemically and/or electrochemically.

6. Method according to Claim 1 or 5, **characterized in that** particles (14) bound to the metal surface are ultrasonically dislodged for separation.

7. Method according to Claim 6, **characterized in that** the particles are dislodged in an aqueous solution, which is then centrifuged to obtain the particles.

8. Method according to one or more of the preceding claims, **characterized in that** the alloy in the particles (14) is monocrystalline.

9. Method according to one of the preceding claims, **characterized in that** the alloy is a nickel-based superalloy.

10. Method according to one of the preceding claims, **characterized in that** the nickel-based superalloy comprises 1-9% by weight aluminium, 0-8% by weight titanium and 0-15% by weight tantalum.

11. Method according to Claim 10, **characterized in that** the alloy is composed of nickel, aluminium, tantalum, chromium, tungsten and molybdenum, to be precise to the following extents:
11.6 at.% Al, 2.4 at.% Ta, 6 at.% Cr, 3.5 at.% W, 1.3 at.% Mo; the remainder being Ni and unavoidable impurities.

12. Method according to one of Claims 1 to 8, **characterized in that** the alloy is a nickel-iron alloy and the particles (14) comprise Ni₃Fe.

13. Method according to Claim 1, **characterized in that** the working surface of the striking tool (33) is smaller than 50 µm, in particular smaller than 5 µm.

14. Method according to Claim 1, **characterized in that** a manipulator with a tungsten tip (34) is used as the striking tool (33) and a silicon cantilever arm (20) is used as an anvil.

15. Method according to Claim 14, **characterized in that** the silicon cantilever arm (20) has a flat surface.

16. Method according to Claim 14, **characterized in that** the silicon cantilever arm (20) has at least one recess which acts as a die.

17. Method according to Claim 16, **characterized in that** the at least one recess has a base face with a maximum dimension of less than 5 µm.

18. Method according to Claim 17, **characterized in that** the recess is produced by nanolithography or microlithography.

19. Method according to one of Claims 14 to 18, **characterized in that** the tungsten tip (34) has a plateau with a diameter of less than 50 µm, in particular less than 5 µm.

20. Method according to one of Claims 14 to 19, **characterized in that** said method is carried out entirely in a scanning electron microscope.

21. Method according to one of Claims 14 to 20, **characterized in that** said method is carried out entirely under a high vacuum.

## Revendications

1. Procédé de fabrication de composants de taille microscopique, **caractérisé par** les étapes suivantes :
a) fabrication d'un alliage consistant en au moins deux phases (Y, Y') pouvant être durci par précipitation, au cours de laquelle une première phase (Y) forme une structure matricielle dans laquelle une deuxième phase (Y') est insérée sous forme de particules (14) discrètes qui présentent une taille inférieure à 10 µm ;
b) dissolution de la matrice et séparation de particules (14) hors de l'alliage ;
c) transformation mécanique, par forgeage avec au moins un outil de percussion (33) à chaque fois d'une particule (14) séparée en un composant souhaité.

2. Procédé selon la revendication 1, **caractérisé en ce que** les particules (14) sont essentiellement en forme de parallélépipède rectangle.

3. Procédé selon la revendication 2, **caractérisé en ce que** les particules (14) sont essentiellement en forme de cube.

4. Procédé selon la revendication 2 ou 3, **caractérisé en ce que** la longueur d'arête maximale est inférieure à 10 µm, de préférence inférieure à 1 µm.

5. Procédé selon l'une quelconque des revendications précédentes, **caractérisé en ce que** la dissolution de la matrice s'effectue chimiquement et/ou électrochimiquement.

6. Procédé selon la revendication 1 ou 5, **caractérisé en ce qu'**on secoue des particules (14) liées sur la surface métallique pour les séparer au moyen d'ultra-sons.

7. Procédé selon la revendication 6, **caractérisé en ce que** le secouage s'effectue dans une solution aqueuse que l'on centrifuge ensuite pour obtenir les particules.

8. Procédé selon l'une ou plusieurs des revendications précédentes, **caractérisé en ce que** l'alliage est monocristallin dans les particules (14).

9. Procédé selon l'une quelconque des revendications précédentes, **caractérisé en ce que** l'alliage est un superalliage à base de nickel.

10. Procédé selon l'une quelconque des revendications précédentes, **caractérisé en ce que** le superalliage à base de nickel comprend 1-9 % massique d'aluminium, 0-8 % massique de titane et 0-15 % massique de tantale.

11. Procédé selon la revendication 10, **caractérisé en ce que** l'alliage se compose de nickel, d'aluminium, de tantale, de chrome, de tungstène et de molybdène, et ce à :
11,6 % atomique Al, 2,4 % atomique Ta, 6 % atomique Cr, 3,5 % atomique W, 1,3 % atomique Mo ; le reste étant du Ni et des impuretés inévitables.

12. Procédé selon l'une quelconque des revendications 1 à 8, **caractérisé en ce que** l'alliage est un alliage nickel-fer et les particules (14) comprennent du Ni₃Fe.

13. Procédé selon la revendication 1, **caractérisé en ce que** la surface de travail de l'outil de percussion (33) est inférieure à 50 µm, en particulier inférieure à 5 µm.

14. Procédé selon la revendication 1, **caractérisé en ce qu'**on a recours en tant qu'outil de percussion (33) à un manipulateur ayant une pointe en tungstène (34) et en tant qu'enclume à un bras en porte-à-faux en silicium (20).

15. Procédé selon la revendication 14, **caractérisé en ce que** le bras en porte-à-faux en silicium (20) présente une surface plane.

16. Procédé selon la revendication 14, **caractérisé en ce que** le bras en porte-à-faux en silicium (20) présente au moins un évidement faisant office d'étampe.

17. Procédé selon la revendication 16, **caractérisé en ce que** l'au moins un évidement a une surface de base dont la dimension maximale est inférieure à 5 µm.

18. Procédé selon la revendication 17, **caractérisé en ce que** l'évidement est produit par nano ou micro-lithographie.

19. Procédé selon l'une quelconque des revendications 14 à 18, **caractérisé en ce que** la pointe en tungstène (34) présente un plateau ayant un diamètre de moins de 50 µm, en particulier moins de 5 µm.

20. Procédé selon l'une quelconque des revendications 14 à 19, **caractérisé en ce qu'**il est entièrement mis en oeuvre dans un microscope électronique à balayage.

21. Procédé selon l'une quelconque des revendications 14 à 20, **caractérisé en ce qu'**il est entièrement mis en oeuvre sous vide poussé.
